# EUROPEAN PATENT SPECIFICATION

(11) **EP 3 599 133 B1**
(45) Date of publication and mention of the grant of the patent: **04.11.2020**
(21) Application number: 18185717.8
(22) Date of filing: 26.07.2018
(51) Int. Cl.: B60R 16/023, H02G 3/10, H02G 3/16, H05K 5/02

(54) **ELECTRIC CONNECTION NODE FOR MOTOR-VEHICLE**
KNOTEN FÜR ELEKTRISCHE VERBINDUNG FÜR KRAFTFAHRZEUG
NOEUD DE CONNEXION ÉLECTRIQUE POUR VÉHICULE À MOTEUR

(43) Date of publication of application: 29.01.2020
(73) Proprietor: FCA Italy S.p.A., 10135 Torino (IT)
(72) Inventor: BALSAMO, Carmelo, I-10042 Nichelino (Torino) (IT); CIARAVOLO, Rosario, I-80040 San Sebastiano al Vesuvio (Napoli) (IT); BIANCO, Leonardo, I-10135 Torino (IT); RUSSO, Domenico, I-10135 Torino (IT)
(74) Representative: Notaro, Giancarlo

(56) References cited:
- US-A- 5 645 448
- US-A1- 2007 219 670
- US-A1- 2011 133 548
- US-A1- 2015 280 342
- US-A1- 2018 048 091

## Description

### Field of the invention

The present invention relates to electric connection nodes for motor-vehicles. In particular, the invention relates to an electric connection node for motor-vehicles, comprising a support casing arranged to be connected to a motor-vehicle floor structure.

### Prior art

Electric connection nodes of the type indicated above are produced for electric connection of power cables provided for electrically connecting different components installed on board the motor-vehicle. With the development of hybrid and electric motor-vehicles, the need to simplify the electrical connection between the various components has become an essential requirement for manufacturers.

### Object of the invention

The object of the present invention is that of proposing an electric connection node for motor-vehicles, which is simpler and more functional than known solutions.

A further object of the present invention is to propose a method for assembling an electric connection node on a motor-vehicle that simplifies the complexity of assembly operations with respect to conventional methods.

### Summary of the invention

In view of achieving one or more of the aforesaid objects, the present invention relates to a motor vehicle according to claim 1. Described herein is also an electric connection node for motor-vehicles, comprising
- a support casing having an upper face, a plurality of side faces and a lower face, said support casing being arranged to be connected to a motor-vehicle floor structure, so that said electric connection node protrudes below the floor structure and said upper face is facing towards said floor structure,
- a first and a second inlet fitting, each provided with a respective connector, wherein said first and second inlet fittings are arranged on at least one side face of the support and are arranged, respectively, for connection to a first and a second power cable,
- a third inlet fitting provided with another connector, wherein said third inlet fitting is arranged at said upper face of the support casing, for electrical connection with a third power cable.

Preferably, the third inlet fitting has an annular portion protruding from said upper face, wherein said protruding annular portion is configured to be arranged within an opening formed on said floor structure, so that said upper face of the support casing is adjacent to the floor structure.

The support casing comprises an annular sealing gasket arranged around said protruding annular portion, a perimetral sealing gasket arranged along the perimeter of the lower face and a pair of annular sealing gaskets arranged around the first and second inlet fittings, respectively, in such a way that the electric connection node is configured to be watertight and can be mounted protruding below the floor structure.

In a concrete embodiment, the first and second power cables are connected at one of their ends which is opposite with respect to the electric connection node, to an alternator assembly and to a lead-acid battery, respectively, arranged in the engine compartment of the motor-vehicle, while the third power cable is connected to a lithium battery rigidly connected to the motor-vehicle floor structure. The lithium battery is connected above said floor structure, said first and second power cables extend below the floor structure, and said third power cable extends above the floor structure.

The disclosure also relates to a method for assembling an electric connection node on a motor-vehicle having the characteristics indicated above.

### Detailed description of the invention

Further characteristics and advantages of the invention will become apparent from the description that follows with reference to the attached drawings, provided purely by way of non-limiting example, wherein:
- Figures 1,2 are perspective views of an electric connection node for motor-vehicles according to the present invention,
- Figure 3 is an exploded perspective view of the electric connection node illustrated in the preceding Figures, and
- Figures 4-6 illustrate perspective views of the electric connection node of the preceding Figures mounted on a floor structure of the motor-vehicle.

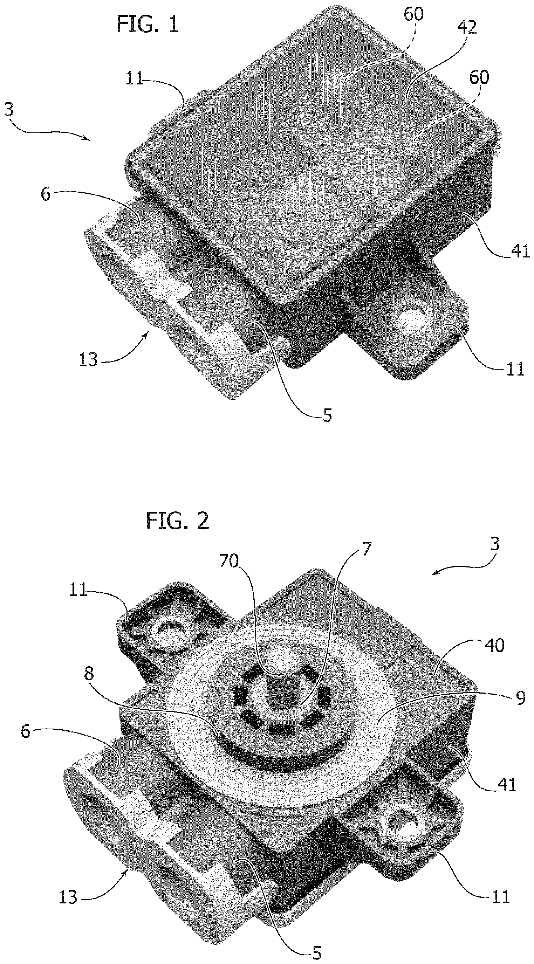

In the attached drawings, numeral 3 indicates a preferred embodiment of an electric connection node for motor-vehicles according to the present invention. With reference, in particular, to Figures 1-3, the electric connection node 3 has a support casing 4 having a parallelepiped shape including an upper face 40, a plurality of side faces 41 and a lower face 42.

As will be illustrated in greater detail below, the support casing 4 can be connected to a motor-vehicle floor structure 1, so that the electric connection node 3 protrudes below the floor structure 1 and the upper face 40 is facing towards the floor structure 1.

The electric connection node 3 includes a first and a second input fitting 5, 6, each provided with a respective connector 50,60, for connection to a first and a second power cable C1, C2, respectively.

In the embodiment illustrated in the drawings, the first and second inlet fittings 5,6 are arranged side-by-side on a side face 41 of the support casing 4 having a quadrangular cross-section.

The electric connection node 3 also includes a third inlet fitting 7 provided with an additional connector 70. In the embodiment illustrated in the drawings, the third inlet fitting 7 is arranged at the upper face 40 of the support casing 4, for connection to a third power cable C3.

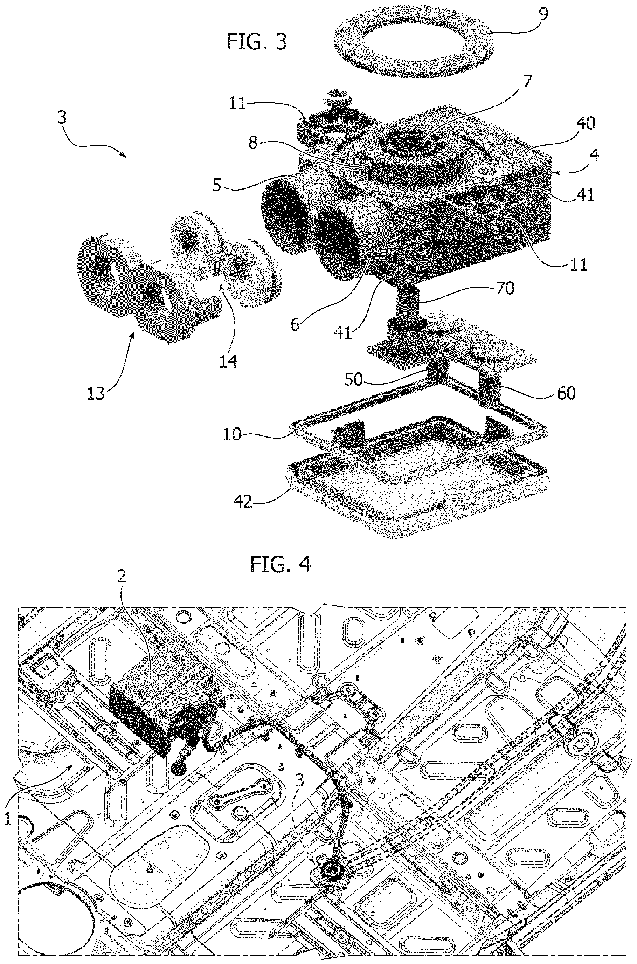

With reference, in particular, to the perspective elevational view of Figure 2 and to the exploded view of Figure 3, the electric connection node 3 according to the invention presents an annular portion 8 protruding from the upper face 40 at the third inlet fitting 7.

The protruding annular portion 8 is configured to be arranged within a corresponding opening formed on a motor-vehicle floor structure 1, so that the upper face 40 of the support casing 4 is adjacent to the floor structure 1 when the node 3 is rigidly connected to the floor structure 1.

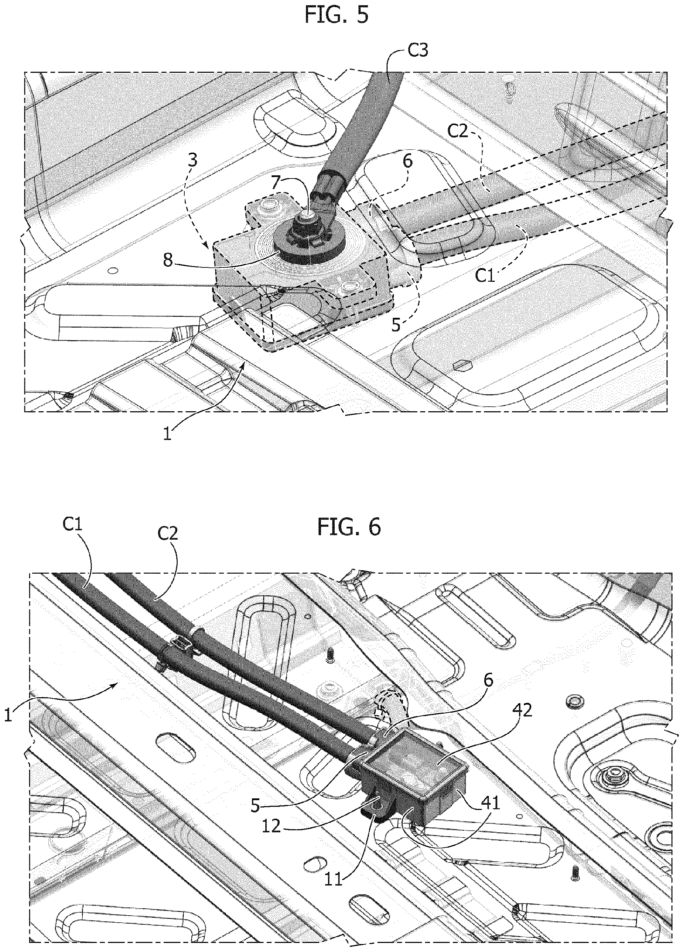

The electric connection node 3 comprises two brackets 11 provided for connection to the motor-vehicle floor structure 1 by means of respective coupling elements 12 (Figures 3 and 6). According to the embodiment illustrated in the drawings, the brackets 11 are arranged on the same plane and at two opposite sides of the upper face 40.

As previously mentioned, the support casing 4 of the connection node 3 can be rigidly connected to a motor-vehicle floor structure 1, so that the electric connection node 3 protrudes below the floor structure 1 and the upper face 40 is facing towards the floor structure 1.

In order to make the electric connection node 3 suitable for this arrangement, the support casing comprises an annular sealing gasket arranged around said protruding annular portion, a perimetral sealing gasket arranged along the perimeter of the lower face and a pair of annular sealing gaskets arranged around the first and second inlet fittings 5,6, respectively, (Figure 3). In the exploded view of Figure 3, a pair of insulating annular elements 14 of elastomeric material are also illustrated, for application, respectively, to the ends of the power cables C1, C2 connected to the fittings 5,6.

Thanks to the production of an electric connection node 3 having the gaskets 9,10,13, and the insulating elements 14, the electric connection node 3 is configured to be watertight, and can be mounted in a protrudable manner below a floor structure 1 without running the risk of malfunctions due to possible water infiltration.

As previously mentioned, each inlet fitting 5,6,7 is provided with a respective connector 50,60,70 to create the electrical connection with a respective power cable C1, C2, C3.

In the embodiment illustrated in the drawings, the connectors 50, 60 of the first and second fittings 5, 6 are conductive bushings included within the support casing 4 and extending in a direction substantially perpendicular to the upper face. The connector 70 of the third fitting 7 is also made in the form of a conductive bushing arranged within the support casing 4, so that an end portion protrudes from the third inlet fitting 7 (Figures 2 and 3).

With reference to a mounted condition of the node 3 on a motor-vehicle floor structure 1, in the following present description, the arrangement of the power cables C1, C2, C3 with respect to the motor-vehicle floor structure 1, and their connection to components installed on board the motor-vehicle, will now be described.

With reference to Figure 4, a portion of a motor-vehicle structure is illustrated, shown in elevation, of the part of the passenger compartment. Reference 2 indicates a lithium battery rigidly connected above the floor structure 1. The third inlet fitting 7 is designed to be connected to the third power cable C3, which is connected at its opposite end to the lithium battery 2.

The first and second inlet fittings 5,6 are arranged for connection with the power cables C1,C2, which are connected at their opposite ends to an alternator assembly and a lead-acid battery, respectively, (not illustrated in the drawings), arranged in the engine compartment of the motor-vehicle.

As illustrated in Figures 4-6, the first and second power cables C1, C2 extend below the floor structure 1, and the third power cable C3 extends above the floor structure 1 (in the passenger compartment of the motor-vehicle).

The present invention also refers to a method for assembling an electric connection node 3 on a motor-vehicle comprising the following steps:
- providing an electric connection node 3 having the characteristics previously indicated,
- connecting the first and second power cables C1, C2 to the first and second input fittings 5,6, so as to produce a pre-assembled assembly including the node 3 and the first and the second power cables C1,C2,,

- mounting the pre-assembled assembly onto a motor-vehicle floor structure 1, so that the assembly protrudes below the motor-vehicle floor structure 1, and the third inlet fitting 7 protrudes into the passenger compartment of the motor-vehicle through an opening formed on the floor structure 1,
- connecting the first and second power cables C1, C2 at their opposite ends - with respect to the electric connection node 3 - to an alternator assembly and to a lead-acid battery, respectively, arranged in the engine compartment of the motor-vehicle, and
- connecting the third power cable C3 to the third inlet fitting 7 protruding inside the passenger compartment and to a lithium battery 2 rigidly connected above the floor structure 1.

With reference to the step of connecting the first and second power cables C1, C2 to the first and second inlet fittings 5, 6, the lower face 42 of the electric connection node is formed of a removable cover (Figure 3) .

The above-described assembly method according to the invention is simple to implement and safe, for ensuring the correct operation of the electric connection node and of the components connected thereto by means of respective power cables.

Thanks to the characteristics previously indicated, the electric connection node according to the invention is particularly effective in achieving its function, simple and with a low production cost.

Of course, without prejudice to the principle of the invention, the details of construction and the embodiments may vary widely with respect to those described and illustrated purely by way of example, without departing from the scope of the present invention.

## Claims

1. A motor-vehicle comprising a floor structure (1), a lithium battery (2) rigidly connected to the floor structure (1), an engine compartment wherein a lead-acid battery and an alternator unit are arranged, said motor-vehicle also comprising an electric connection node (3) for electrically interconnecting the lithium battery, the lead-acid battery and the alternator including:
- a support casing (4) having an upper face (40), a plurality of side faces (41) and a lower face (42), said support casing (4) being connected to a floor structure (1), so that said electric connection node (3) protrudes below the floor structure (1) and said upper face is facing towards said floor structure (1),
- a first and a second inlet fitting (5,6), each provided with a respective connector (50,60), wherein said first and second inlet fittings (5,6) are arranged on at least one side face (41) of the support (4) and are connected, respectively, to a first and a second power cable, said first and second power cables (C1, C2) being connected at their opposite ends to the alternator assembly and to the lead-acid battery, respectively,
- a third inlet fitting (7) arranged at said upper face (40) and provided with a further connector (70), connected to a third power cable (C3) which is connected at its opposite end to said lithium battery (2) .

2. A motor-vehicle according to claim 1, **characterized in that** said lithium battery (2) is connected above said floor structure (1), said first and second power cables (C1, C2) extend below the floor structure (1) and said third power cable (C3) extends above said floor structure (1).

3. A motor-vehicle according to claim 2, **characterized in that** said third inlet fitting (7) has an annular portion protruding from said upper face (40), wherein said protruding annular portion is configured to be arranged within an opening formed on said floor structure (1), so that said upper face (40) of the support casing (4) is adjacent to the floor structure (1).

4. A motor-vehicle according to claim 3, **characterized in that** said support casing (4) comprises an annular sealing gasket (9) arranged around said protruding annular portion and a perimetral sealing gasket (10) arranged along the perimeter of said lower face, in such a way that said electric connection node (3) is configured to seal in a watertight manner, and can be mounted protruding below a floor structure (1).

5. A motor-vehicle according to claim 4, **characterized in that** the support casing (4) also comprises a pair of sealing annular gaskets (13) arranged around said first and said second inlet fittings (5,6), respectively.

6. A motor-vehicle according to claim 1, **characterized in that** said connectors (50, 60) in association with the first and second inlet fittings (5,6) are conductive bushings included within the support casing (4) and extending in a direction substantially perpendicular to said upper face (40).

7. A motor-vehicle according to claim 1, **characterized in that** said additional connector (70) associated with said third inlet fitting (7) is an additional conductive bushing arranged within the support casing (4), so that an end portion protrudes from said third inlet fitting (7).

8. A motor-vehicle according to claim 1, **characterized in that** the support casing (4) has a quadrangular cross-section and has the first and second inlet fittings (5,6) side-by-side at a side face (41) of the support casing (4).

9. A motor-vehicle according to claim 1, **characterized in that** the electric connection node (3) also comprises two brackets (11) arranged for connection to the motor-vehicle floor structure (1), by means of respective coupling elements (12), said brackets (11) being arranged on the same plane and at two opposite sides of said upper face (40).

## Patentansprüche

1. Kraftfahrzeug, umfassend eine Bodenstruktur (1), eine Lithiumbatterie (2), die starr mit der Bodenstruktur (1) verbunden ist, einen Motorraum, in dem eine Blei-Säure-Batterie und eine Lichtmaschineneinheit angeordnet sind, wobei das Kraftfahrzeug zudem einen elektrischen Verbindungsknoten (3) zum elektrischen Verbinden der Lithiumbatterie, der Blei-Säure-Batterie und der Lichtmaschine umfasst, umfassend:
- ein Haltegehäuse (4) mit einer Oberseite (40), mehreren Seitenflächen (41) und einer Unterseite (42), wobei das Haltegehäuse (4) mit einer Bodenstruktur (1) verbunden ist, so dass der elektrische Verbindungsknoten (3) unter der Bodenstruktur (1) hervorsteht und die Oberseite zur Bodenstruktur (1) zeigt,
- ein erstes und ein zweites Einlasspassstück (5, 6), die jeweils mit einem entsprechenden Verbinder (50, 60) versehen sind, wobei das erste und das zweite Einlasspassstück (5, 6) auf wenigstens einer Seitenfläche (41) der Halterung (4) angeordnet sind und jeweils mit einem ersten und einem zweiten Stromkabel verbunden sind, wobei das erste und das zweite Stromkabel (C1, C2) an ihren gegenüberliegenden Enden mit der Lichtmaschinenanordnung bzw. mit der Blei-Säure-Batterie verbunden sind, und
- ein drittes Einlasspassstück (7), das an der Oberseite (40) angeordnet und mit einem weiteren Verbinder (70) versehen ist, der mit einem dritten Stromkabel (C3) verbunden ist, das an seinem gegenüberliegenden Ende mit der Lithiumbatterie (2) verbunden ist.

2. Kraftfahrzeug nach Anspruch 1, **dadurch gekennzeichnet, dass** die Lithiumbatterie (2) über der Bodenstruktur (1) angeschlossen ist, sich das erste und das zweite Stromkabel (C1, C2) unter der Bodenstruktur (1) erstrecken und sich das dritte Stromkabel (C3) über der Bodenstruktur (1) erstreckt.

3. Kraftfahrzeug nach Anspruch 2, **dadurch gekennzeichnet, dass** das dritte Einlasspassstück (7) einen ringförmigen Abschnitt aufweist, der aus der oberen Fläche (40) herausragt, wobei der hervorragende ringförmige Abschnitt so konfiguriert ist, dass er innerhalb einer Öffnung angeordnet ist, die auf der Bodenstruktur (1) ausgebildet ist, so dass die Oberseite (40) des Haltegehäuses (4) an die Bodenstruktur (1) angrenzt.

4. Kraftfahrzeug nach Anspruch 3, **dadurch gekennzeichnet, dass** das Haltegehäuse (4) eine ringförmige Dichtung (9), die um den hervorstehenden ringförmigen Abschnitt angeordnet ist, und eine Umfangsdichtung (10) umfasst, die entlang des Umfangs der Unterseite so angeordnet ist, dass der elektrische Verbindungsknoten (3) dazu eingerichtet ist, dass er wasserdicht abdichtet, und unter einer Bodenstruktur (1) hervorstehend montiert werden kann.

5. Kraftfahrzeug nach Anspruch 4, **dadurch gekennzeichnet, dass** das Haltegehäuse (4) auch ein Paar Dichtringdichtungen (13) umfasst, die um das erste bzw. das zweite Einlasspassstück (5, 6) angeordnet sind.

6. Kraftfahrzeug nach Anspruch 1, **dadurch gekennzeichnet, dass** die Verbinder (50, 60) in Verbindung mit dem ersten und zweiten Einlasspassstück (5, 6) leitende Buchsen sind, die in dem Haltegehäuse (4) enthalten sind und sich in einer Richtung im wesentlichen senkrecht zu der Oberseite (40) erstrecken.

7. Kraftfahrzeug nach Anspruch 1, **dadurch gekennzeichnet, dass** der zusätzliche Verbinder (70), der dem dritten Einlasspassstück (7) zugeordnet ist, eine zusätzliche leitende Buchse ist, die in dem Haltegehäuse (4) angeordnet ist, so dass ein Endabschnitt von dem dritten Einlasspassstück (7) hervorsteht.

8. Kraftfahrzeug nach Anspruch 1, **dadurch gekennzeichnet, dass** das Haltegehäuse (4) einen viereckigen Querschnitt aufweist und über das erste und das zweite Einlasspassstück (5, 6) nebeneinander an einer Seitenfläche (41) des Haltegehäuses (4) verfügt.

9. Kraftfahrzeug nach Anspruch 1, **dadurch gekennzeichnet, dass** der elektrische Verbindungsknoten (3) auch zwei Konsolen (11) aufweist, die zur Verbindung mit der Kraftfahrzeugbodenstruktur (1) mittels entsprechender Kupplungselemente (12) eingerichtet sind, wobei die Konsolen (11) in derselben Ebene und an zwei gegenüberliegenden Seiten der Oberseite (40) angeordnet sind.

## Revendications

1. Véhicule automobile comprenant une structure de plancher (1), une batterie au lithium (2) reliée rigidement à la structure de plancher (1), un compartiment moteur dans lequel une batterie au plomb-acide et une unité d'alternateur sont agencées, ledit véhicule automobile comprenant également un nœud de connexion électrique (3) pour interconnecter électriquement la batterie au lithium, la batterie au plomb-acide et l'alternateur, comportant :
- un boîtier de support (4) ayant une face supérieure (40), une pluralité de faces latérales (41) et une face inférieure (42), ledit boîtier de support (4) étant relié à une structure de plancher (1), de sorte que ledit nœud de connexion électrique (3) fasse saillie en dessous de la structure de plancher (1) et ladite la face supérieure soit tournée vers ladite structure de plancher (1),
- des premier et deuxième raccords d'entrée (5,6), chacun pourvu d'un connecteur respectif (50, 60), où lesdits premier et deuxième raccords d'entrée (5, 6) sont agencés sur au moins une face latérale (41) du support (4) et sont reliés, respectivement, à des premier et deuxième câbles d'alimentation, lesdits premier et deuxième câbles d'alimentation (C1, C2) étant reliés au niveau de leurs extrémités opposées à l'ensemble alternateur et à la batterie au plomb-acide, respectivement,
- un troisième raccord d'entrée (7) agencé au niveau de ladite face supérieure (40) et pourvu d'un connecteur supplémentaire (70), relié à un troisième câble d'alimentation (C3) qui est relié au niveau de son extrémité opposée à ladite batterie au lithium (2).

2. Véhicule automobile selon la revendication 1, **caractérisé en ce que** ladite batterie au lithium (2) est reliée au-dessus de ladite structure de plancher (1), lesdits premier et deuxième câbles d'alimentation (C1, C2) s'étendent sous la structure de plancher (1) et ledit troisième câble d'alimentation (C3) s'étend au-dessus de ladite structure de plancher (1).

3. Véhicule automobile selon la revendication 2, **caractérisé en ce que** ledit troisième raccord d'entrée (7) a une partie annulaire faisant saillie à partir de ladite face supérieure (40), où ladite partie annulaire en saillie est configurée pour être agencée à l'intérieur d'une ouverture formée sur ladite structure de plancher (1), de sorte que ladite face supérieure (40) du boîtier de support (4) soit adjacente à la structure de plancher (1).

4. Véhicule automobile selon la revendication 3, **caractérisé en ce que** ledit boîtier de support (4) comprend un joint d'étanchéité annulaire (9) agencé autour de ladite partie annulaire en saillie et un joint d'étanchéité périphérique (10) agencé le long du périmètre de ladite face inférieure, de manière à ce que ledit nœud de connexion électrique (3) soit configuré pour sceller de manière étanche, et puisse être monté en saillie en dessous d'une structure de plancher (1).

5. Véhicule automobile selon la revendication 4, **caractérisé en ce que** le boîtier de support (4) comprend également une paire de joints d'étanchéité annulaires (13) agencés autour desdits premier et deuxième raccords d'entrée (5, 6), respectivement.

6. Véhicule automobile selon la revendication 1, **caractérisé en ce que** lesdits connecteurs (50, 60) en association avec les premier et deuxième raccords d'entrée (5, 6) sont des douilles conductrices incluses dans le boîtier de support (4) et s'étendant dans une direction essentiellement perpendiculaire à ladite face supérieure (40).

7. Véhicule automobile selon la revendication 1, **caractérisé en ce que** ledit connecteur supplémentaire (70) associé audit troisième raccord d'entrée (7) est une douille conductrice supplémentaire agencée à l'intérieur du boîtier de support (4), de sorte qu'une partie d'extrémité fasse saillie à partir dudit troisième raccord d'entrée (7).

8. Véhicule automobile selon la revendication 1, **caractérisé en ce que** le boîtier de support (4) présente une section transversale quadrangulaire et a les premier et deuxième raccords d'entrée (5,6) côte à côte au niveau d'une face latérale (41) du boîtier de support (4).

9. Véhicule automobile selon la revendication 1, **caractérisé en ce que** le nœud de connexion électrique (3) comprend également deux pattes de fixation (11) agencées pour être reliées à la structure de plancher de véhicule automobile (1), au moyen d'éléments de couplage respectifs (12), lesdites pattes de fixation (11) étant agencées sur le même plan et au niveau de deux côtés opposés de ladite face supérieure (40).
